Europäisches Patentamt

European Patent Office

Office européen des brevets

(19)

(11) EP 1 130 717 A2

(12) **EUROPEAN PATENT APPLICATION**

(43) Date of publication:
05.09.2001 Bulletin 2001/36

(51) Int Cl.7: **H01S 5/14**, H01S 5/028

(21) Application number: 00126707.9

(22) Date of filing: 05.12.2000

| | |
|---|---|
| (84) Designated Contracting States:<br>**AT BE CH CY DE DK ES FI FR GB GR IE IT LI LU MC NL PT SE TR**<br>Designated Extension States:<br>**AL LT LV MK RO SI**<br><br>(30) Priority: 06.12.1999 JP 34572499<br>29.05.2000 JP 2000157792<br>29.06.2000 JP 2000196166<br>26.10.2000 JP 2000326383 | (71) Applicant: **Fuji Photo Film Co., Ltd.**<br>**Kanagawa-ken (JP)**<br><br>(72) Inventors:<br>• **Shinichiro, Sonoda, c/o Fuji Photo Film Co., Ltd.**<br>**Ashigarakami-gun, Kanagawa-ken (JP)**<br>• **Chiaki, Goto, c/o Fuji Photo Film Co., Ltd.**<br>**Ashigarakami-gun, Kanagawa-ken (JP)**<br><br>(74) Representative: **Klunker . Schmitt-Nilson . Hirsch**<br>**Winzererstrasse 106**<br>**80797 München (DE)** |

(54) **Semiconductor laser light source with external cavity**

(57)     In a laser light source comprised of a semiconductor light-emitting element and a waveguide-type wavelength selection element, the semiconductor light-emitting element emits light, and the waveguide-type wavelength selection element selects a wavelength of the light emitted from the semiconductor light-emitting element. A first end face of the semiconductor light-emitting element and an end face of the waveguide-type wavelength selection element are butt-coupled. An antireflection optical system for the wavelength selected by the waveguide-type wavelength selection element is formed between the first end face of the semiconductor light-emitting element and the end face of the waveguide-type wavelength selection element. A second end face of the semiconductor light-emitting element and the waveguide-type wavelength selection element form an external resonator in which light having the wavelength selected by the waveguide-type wavelength selection element resonates. The light which resonates in the external resonator exits from the second end face of the semiconductor light-emitting element.

F I G . 1

RESONATOR

EP 1 130 717 A2

## Description

BACKGROUND OF THE INVENTION

Field of the Invention

The present invention relates to a laser light source in which a wavelength of light emitted from a semiconductor laser device is selected by using an external resonator including a wavelength selection element so as to obtain a laser beam having the selected wavelength. In addition, the present invention relates to an image forming apparatus in which the above laser light source is used for recording an image.

Description of the Related Art

In a conventional laser light source as disclosed in Japanese Unexamined Patent Publication No. 10(1998)-254001, a semiconductor light-emitting element such as a semiconductor laser device is coupled to an external resonator including a wavelength selection element such as a narrow-band-pass filter, and the wavelength of laser light which oscillates in the external resonator is locked at a desired wavelength. The external resonator may be a conventional type which is formed with mirrors, or a type in which a grating formed along an optical waveguide selects a wavelength of guided light, and reflects and diffracts the guided light having the selected wavelength, or another type.

In the above conventional laser light source, the above external resonator and a Fabry-Perot resonator formed in the semiconductor light-emitting element form a composite resonator, and therefore the laser light source can oscillate at different wavelengths determined by the respective resonators.

JUPP 10-254001 also discloses a technique in which an optical wavelength conversion element is coupled to a semiconductor light-emitting element as mentioned above so as to convert a laser beam into a second harmonic or the like. In a conventional optical wavelength conversion element, an optical waveguide is formed in a direction on a ferroelectric crystal substrate having a nonlinear optical effect, a plurality of domain-inverted portions are periodically formed on the optical waveguide, and the direction of the spontaneous polarization in each domain-inverted portion is inverted, so that the wavelength of the fundamental wave which propagates along the plurality of domain-inverted portions is converted.

However, in a laser light source in which an external resonator including a wavelength selection element is coupled to a semiconductor light-emitting element, the so-called mode hopping occurs, i.e., the oscillation wavelength varies with variation of the optical length of the semiconductor light-emitting element, which is caused by variation of the driving current of the semiconductor light-emitting element. Therefore, in image forming apparatuses which use the above laser light source as a recording light source for production of images having density gradation, noise is produced when the driving current is varied in order to vary the intensity of the laser light for realizing the density gradation. Consequently, it is impossible to form high-quality images with the above image forming apparatus.

In addition, since repeatability of the driving current-optical output characteristic in the above laser light source is lowered in the range of the driving current in which the mode hopping occurs, it is impossible to obtain a modulated output from the above laser light source with high repeatability. That is, the repeatability of the image density is also lowered.

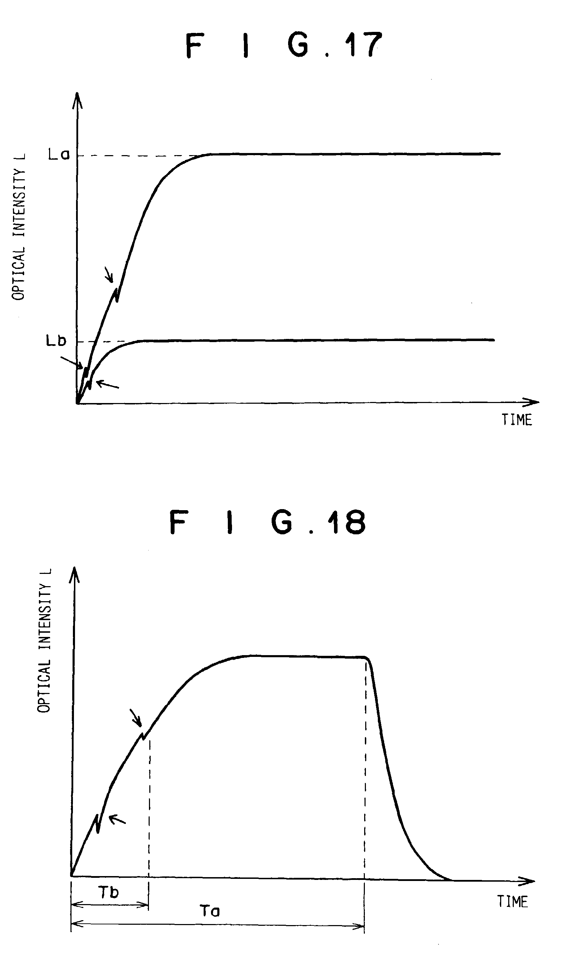

Fig. 17 is a diagram illustrating two examples of variation of the optical intensity in the case where the above laser light source is used as a recording light source, and is subject to intensity modulation. In Fig. 17, one of the examples exhibits variation of the optical intensity when the optical intensity is increased to a relatively high level La, and the other example exhibits variation of the optical intensity when the optical intensity is increased to a relatively low level Lb. As indicated by the arrows in Fig. 17, in each example, noise due to mode hopping is produced when the optical intensity is increased.

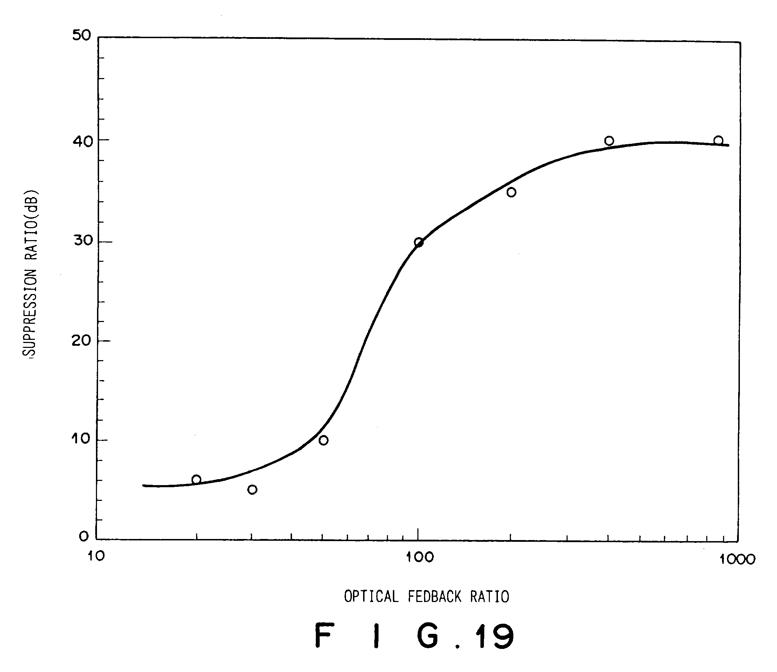

Fig. 18 is a diagram illustrating an example of variation of the optical intensity in the case where the above laser light source is used as a recording light source, and is subject to pulse width modulation. In the example of Fig. 18, the modulation is performed with a relatively long pulse width Ta and a relatively short pulse width Tb. As indicated by the arrows in Fig. 18, noise due to mode hopping is also produced when the optical intensity is increased. In addition, the timing at which the mode hopping occurs varies when a pulse width (such as Tb) is so short that the increase in the optical intensity is discontinued before the optical intensity reaches a predetermined pulse height. Therefore, repeatability of the driving current-optical output characteristic of the laser light source becomes extremely low.

In particular, the above problem is worsened when the above laser light source is coupled to the aforementioned optical wavelength conversion element. For example, when the above laser light source is coupled to an optical wavelength conversion element which converts a fundamental wave into a second harmonic, the output power of the second harmonic is proportional to the square of the output power of the fundamental wave. Therefore, the output power of the second harmonic greatly varies, and the repeatability of the driving current-optical output characteristic of the laser light source is further lowered. Therefore, when the above laser light source is coupled to an optical wavelength conversion element, and the wavelength-converted laser light is used as a recording light in an image forming apparatus, it is impossible to directly modulate the semiconductor light-emitting element. That is, it is necessary to provide an external modulator such as an acousto-optic modulator (AOM). Therefore, the cost and size of the image forming apparatus increase.

In another conventional technique, a high frequency component is superimposed on a driving current of the semiconductor light-emitting element so as to suppress the mode hopping. However, since high frequency circuits are expensive, the above technique also increases the cost. In addition, the high frequency circuits produce noise.

In order to solve the above problems, for example, Applied Physics Letters, 47(3), August 1, 1985, pp.183-185 discloses a laser light source which oscillates substantially only at a wavelength selected by an external resonator. This laser light source is formed by directly coupling a semiconductor light-emitting element to an external resonator having a function of selecting a wavelength, and antireflection (AR) coatings for the selected wavelength are provided on end faces at which the semiconductor light-emitting element and the external resonator are is coupled. Due to the above construction, no Fabry-Perot mode exists between opposite end faces of the semiconductor light-emitting element, and therefore laser oscillation occurs substantially only in the external resonator. That is, the laser light source substantially oscillates at the wavelength selected by the external resonator.

However, in the above laser light source, the laser beam oscillated in the external resonator is output through the wavelength selection element. Therefore, the internal power of the semiconductor light-emitting element becomes great, and the semiconductor light-emitting element is prone to damage.

SUMMARY OF THE INVENTION

An object of the present invention is to provide a laser light source comprised of a semiconductor light-emitting element and a waveguide-type wavelength selection element coupled to the semiconductor light-emitting element, wherein noise production due to mode hopping and damage of the semiconductor light-emitting element due to increase in internal power can be prevented.

Another object of the present invention is to provide an image forming apparatus which uses as a recording light source a laser light source comprised of a semiconductor light-emitting element and a waveguide-type wavelength selection element coupled to the semiconductor light-emitting element, wherein influence of noise produced due to mode hopping can be reduced, and a high-quality image can be produced.

According to the first aspect of the present invention, there is provided a laser light source comprising a semiconductor light-emitting element and a waveguide-type wavelength selection element. The semiconductor light-emitting element has first and second end faces at opposite ends thereof, and emits light.

The waveguide-type wavelength selection element has a third end face at one end thereof, and selects a wavelength of the light emitted from the semiconductor light-emitting element. The first end face of the semiconductor light-emitting element and the third end face of the waveguide-type wavelength selection element are butt-coupled. An antireflection optical system for the wavelength selected by the waveguide-type wavelength selection element is formed between the first end face of the semiconductor light-emitting element and the third end face of the waveguide-type wavelength selection element. The second end face of the semiconductor light-emitting element and the waveguide-type wavelength selection element form an external resonator in which light having the wavelength selected by the waveguide-type wavelength selection element resonates. The light which resonates in the external resonator exits from the second end face of the semiconductor light-emitting element.

According to the second aspect of the present invention, there is provided a laser light source comprising a semiconductor light-emitting element, a waveguide-type wavelength selection element, and an optical wavelength conversion element. The semiconductor light-emitting element has first and second end faces at opposite ends thereof, and emits light. The waveguide-type wavelength selection element has a third end face at one end thereof, and selects a wavelength of the light emitted from the semiconductor light-emitting element, where the first end face of the semiconductor light-emitting element and the third end face of the waveguide-type wavelength selection element are optically coupled, an antireflection optical system for the wavelength selected by the waveguide-type wavelength selection element is formed between the first end face of the semiconductor light-emitting element and the third end face of the waveguide-type wavelength selection element, and the second end face of the semiconductor light-emitting element and the waveguide-type wavelength selection element form an external resonator in which light having the wavelength selected by the waveguide-type wavelength selection element resonates. The optical wavelength conversion element is butt-coupled to at least one of the semiconductor light-emitting element and the waveguide-type wavelength selection element so that the semiconductor light-emitting element, the waveguide-type wavelength selection element, and the optical wavelength conversion element are butt-coupled, and the optical wavelength conversion element converts the wavelength of the light which resonates in said external resonator, into another wavelength, and outputs light having the converted wavelength.

In the first and second aspects of the present invention, the butt coupling of a first element to a second element means optical coupling of the first element to the second element without inserting an optical lens system between the first and second elements. In this case, the first and second elements may or may not be in contact with each other.

In the second aspect of the present invention, the optical wavelength conversion element may be butt-coupled to one end of a construction which is formed by butt-coupling the waveguide-type wavelength selection element to the semiconductor light-emitting element. Alternatively, the optical wavelength conversion element may be arranged between the semiconductor light-emitting element and the waveguide-type wavelength selection element, and butt-connected to each of the semiconductor light-emitting element and the waveguide-type wavelength selection element.

According to the third aspect of the present invention, there is provided an image forming apparatus which comprises the laser light source according to the first aspect of the present invention as a light source for recording an image having density gradation.

According to the fourth aspect of the present invention, there is provided an image forming apparatus which comprises the laser light source according to the second aspect of the present invention as a light source for recording an image having density gradation.

Preferably, the laser light source according to the first or second aspect of the present invention may also have one or any possible combination of the following additional features (i) to (vii).

(i) Antireflection coatings may be provided on the first end face of the semiconductor light-emitting element and the third end face of the waveguide-type wavelength selection element so as to form the antireflection optical system.
(ii) The antireflection optical system may have a reflectance of 0.5% or less at the wavelength selected by the waveguide-type wavelength selection element.
(iii) In order to form the antireflection optical system, the first end face of the semiconductor light-emitting element and the third end face of the waveguide-type wavelength selection element may have an approximately identical reflectance at the wavelength selected by the waveguide-type wavelength selection element, and the distance between the first end face of the semiconductor light-emitting element and the third end face of the waveguide-type wavelength selection element may be an approximately half-integer multiple of the wavelength selected by the waveguide-type wavelength selection element.
(iv) In order to form the antireflection optical system, the first end face of the semiconductor light-emitting element and the third end face of the waveguide-type wavelength selection element may have a reflectance of 0.1 to 0.8% at the wavelength selected by the waveguide-type wavelength selection element, and the distance between the first end face of the semiconductor light-emitting element and the third end face of the waveguide-type wavelength selection element may be {(2N-1)/2 - 0.25} to {(2N-1)/2 + 0.25} times the wavelength selected by the waveguide-type wavelength selection element, where N is an arbitrary natural number.
(v) The wavelength selection element may comprise a reflective grating by which the wavelength is selected.
(vi) The distance between the first end face of the semiconductor light-emitting element and the third end face of the waveguide-type wavelength selection element may be 1.5 times the wavelength selected by the waveguide-type wavelength selection element or less.
(vii) The other end of the waveguide-type wavelength selection element, which is located opposite to the third end face, may be cut at a bevel with respect to a direction in which an optical waveguide in the waveguide-type wavelength selection element extends.

The advantages of the present invention are as follows.

In the laser light source according to the first aspect of the present invention, an antireflection optical system for the wavelength selected by the waveguide-type wavelength selection element is formed between the first end face of the semiconductor light-emitting element and the third end face of the waveguide-type wavelength selection element, and the second end face of the semiconductor light-emitting element and the waveguide-type wavelength selection element form an external resonator in which light having the wavelength selected by the waveguide-type wavelength selection element resonates. Therefore, substantially no Fabry-Perot mode exists between the first and second end faces of the semiconductor light-emitting element, and laser oscillation occurs substantially only in the above external resonator at the wavelength selected in the external resonator. Consequently, in the laser light source according to the first aspect of the present invention, the mode hopping and the noise production caused by the mode hopping can be prevented.

In addition, in the laser light source according to the first aspect of the present invention, the light which resonates in the external resonator is output from the second end face of the semiconductor light-emitting element, which is the end face located farther from the waveguide-type wavelength selection element than the other (first) end face of the semiconductor light-emitting element. Therefore, the internal power of the semiconductor light-emitting element can be lowered, compared with the conventional laser light source in which the laser beam is output through the wavelength selection element. Consequently, it is possible to prevent the semiconductor light-emitting element from being damaged due to increase in the internal power.

In the conventional laser light source in which laser light oscillated in the external resonator is output through the wavelength selection element, the semiconductor light-emitting element must generate additional laser power in order to compensate for coupling loss at the coupling of the semiconductor light-emitting element to the wavelength selection element and transmission loss in the wavelength selection element. On the other hand, in the laser light source according to the first aspect of the present invention, the laser light is output from the end face of the semiconductor light-emitting element which is located farther from the wavelength selection element than the other end face of the semiconductor light-emitting element. Therefore, the above coupling loss and transmission loss occur only as resonator loss, and do not cause the increase in the internal power of the semiconductor light-emitting element.

Even in InGaAs-based semiconductor light-emitting elements, which are relatively resistant to optical damage, the internal power density of the semiconductor light-emitting element which causes catastrophic optical damage is considered to be 18 to 19 MW/cm$^2$, which corresponds to the internal power of 540 to 570 mW when the area of the emission spot is 3 $\mu$m$^2$. However, in practice, semiconductor light-emitting elements usually break down with lower internal power, due to defects existing in the semiconductor light-emitting elements or the like. Therefore, in order to obtain an optical output of 100 mW or more, which is a fraction of the above internal power causing the catastrophic optical damage, it is important to suppress the internal power density. Thus, it is advantageous for high-power lasers to output laser beams from the end face of the semiconductor light-emitting element which is located farther from the waveguide-type wavelength selection element than the other end face of the semiconductor light-emitting element.

In the laser light source according to the second aspect of the present invention, substantially no Fabry-Perot mode exists between the first and second end faces of the semiconductor light-emitting element for the same reason as the first aspect of the present invention, and laser oscillation occurs substantially only in the aforementioned external resonator at the wavelength selected in the external resonator. Consequently, the mode hopping and the noise production caused by the mode hopping can also be prevented in the laser light source according to the second aspect of the present invention.

In particular, the laser light source according to the second aspect of the present invention further comprises an optical wavelength conversion element. As mentioned before, for example, when the optical wavelength conversion element generates a second harmonic, the output power of the second harmonic is proportional to the square of the output power of the fundamental wave. Therefore, if mode hopping occurs, and noise due to the mode hopping is produced, the output power of the second harmonic greatly varies, and repeatability of the driving current-optical output characteristic of the laser light source becomes low. However, the mode hopping and the noise production caused by the mode hopping can be prevented in the laser light source according to the second aspect of the present invention. Therefore, the output power of the optical wavelength conversion element, e.g., the second harmonic, does not vary, and the repeatability of the driving current-optical output characteristic of the laser light source does not become low. Consequently, the laser light source according to the second aspect of the present invention has great practical value.

Fig. 19 is a diagram illustrating a relationship between an optical feedback ratio and a suppression ratio (dB). The optical feedback ratio is a ratio of an amount of light fed back from the external resonator to an amount of light fed back from the antireflection-coated surface of the semiconductor light-emitting element, and the suppression ratio is a ratio of an amount of light corresponding to the primary oscillation mode which is selected by the wavelength selection element, to an amount of light corresponding to the secondary oscillation mode or background. The result of Fig. 19 is obtained from a semiconductor light-emitting element having an InGaAs active layer, an emission spot of 1 $\mu$m X 3 $\mu$m, and an antireflection coating with a reflectance of 0.07 to 5%, where the feedback efficiency of the light fed back from the external resonator is 20 to 60%. As illustrated in Fig. 19, it is clear that the secondary oscillation mode can be satisfactorily suppressed when the above optical feedback ratio exceeds 100.

Further, when the laser light source according to the second aspect of the present invention is arranged so that the laser beam generated by the oscillation in the external resonator is output from the end face of the semiconductor light-emitting element which is farther from the wavelength selection element than the other end face of the semiconductor light-emitting element, the internal power of the semiconductor laser element can be lowered, compared with the laser light source in which the laser beam oscillated in the external resonator is output through the wavelength selection element, and therefore, it is possible to prevent the semiconductor light-emitting element from being damaged due to the increase in the internal power.

In the case where the aforementioned antireflection optical system has a reflectance of 0.5% or less at the wavelength selected by the waveguide-type wavelength selection element, it is possible to realize oscillation at the wavelength selected by the waveguide-type wavelength selection element, for example, under the condition that the efficiency of feedback from the external resonator is 50%, which is a practicable value.

When the guided light propagated through the waveguide-type wavelength selection element has a profile corresponding to the emission spot of the semiconductor light-emitting element, and the distance between the first end face of the semiconductor light-emitting element and the third end face of the waveguide-type wavelength selection element is 1.5 times the wavelength selected by the waveguide-type wavelength selection element or less, the efficiency of feedback from the external resonator becomes 50%.

The reflectance of the antireflection optical system can be reduced to 0.5% or less by using the conventional inexpensive antireflection coatings. Therefore, it is possible to increase the amount of the light fed back from the wavelength selection element, to at least about a hundred times the amount of the light reflected at the end faces, although the light reflected at the end faces conventionally causes unnecessary oscillation. That is, the major portion of the light oscillated in the laser light source has the wavelength selected by the wavelength selection element. Thus, the oscillation in the laser light source becomes stable.

When the other end of the waveguide-type wavelength selection element, which is located opposite to the above end face which is optically coupled to the end face of the semiconductor light-emitting element, is cut at a bevel with respect to the direction in which the optical waveguide in the waveguide-type wavelength selection element extends, light reflected at the beveled end face does not enter the optical waveguide in the wavelength selection element, and therefore does not return to the semiconductor light-emitting element. Thus, it is possible to prevent noise production and variation of the output power which are caused by the light returned to the semiconductor light-emitting element.

Since the image forming apparatus according to the third or fourth aspects of the present invention comprises, as a light source for recording an image having density gradation, the laser light source according to the first or second aspect of the present invention, it is possible to prevent deterioration in image quality due to the aforementioned noise, and in particular images having density gradation can be recorded with high quality.

DESCRIPTION OF THE DRAWINGS

Fig. 1 is a diagram illustrating the construction of a laser light source as the first embodiment of the present invention.

Fig. 2 is a diagram schematically illustrating a relationship between the driving current and the oscillation wavelength in the conventional laser light source.

Fig. 3 is a diagram schematically illustrating a relationship between the driving current and the oscillation wavelength in the laser light source as the first embodiment.

Fig. 4 is a diagram schematically illustrating a relationship between the driving current and the output power of the above conventional laser light source.

Fig. 5 is a diagram schematically illustrating a relationship between the driving current and the output power of the above laser light source as the first embodiment.

Fig. 6 is a diagram illustrating the construction of a laser light source as the second embodiment of the present invention.

Fig. 7 is a diagram schematically illustrating a relationship between the driving current and the output power of a second harmonic in a conventional laser light source.

Fig. 8 is a diagram schematically illustrating a relationship between the driving current and the output power of the second harmonic in the laser light source as the second embodiment.

Fig. 9 is a diagram illustrating the construction of a laser light source as the third embodiment of the present invention.

Fig. 10 is a diagram illustrating the construction of a laser light source as the fourth embodiment of the present invention.

Fig. 11 is a diagram illustrating the construction of a laser light source as the fifth embodiment of the present invention.

Fig. 12 is a diagram illustrating the construction of a laser light source as the sixth embodiment of the present invention.

Fig. 13 is a diagram illustrating an example of an arrangement for use of the laser light source illustrated in Fig. 1.

Fig. 14 is a diagram illustrating an example of an arrangement for use of the laser light source illustrated in Fig. 6.

Fig. 15 is a diagram illustrating the construction of an image forming apparatus as the seventh embodiment of the present invention.

Fig. 16 is a diagram illustrating the construction of an image forming apparatus as the eighth embodiment of the present invention.

Fig. 17 is a diagram illustrating examples of variation of the optical intensity in the case where a conventional laser light source is used as a recording light source, and is subject to intensity modulation.

Fig. 18 is a diagram illustrating an example of variation of the optical intensity in the case where a conventional laser light source is used as a recording light source, and is subject to pulse width modulation.

Fig. 19 is a diagram illustrating a relationship between an optical feedback ratio and a suppression ratio.

DESCRIPTION OF PREFERRED EMBODIMENTS

Embodiments of the present invention are explained in detail below with reference to drawings.

(1) First Embodiment

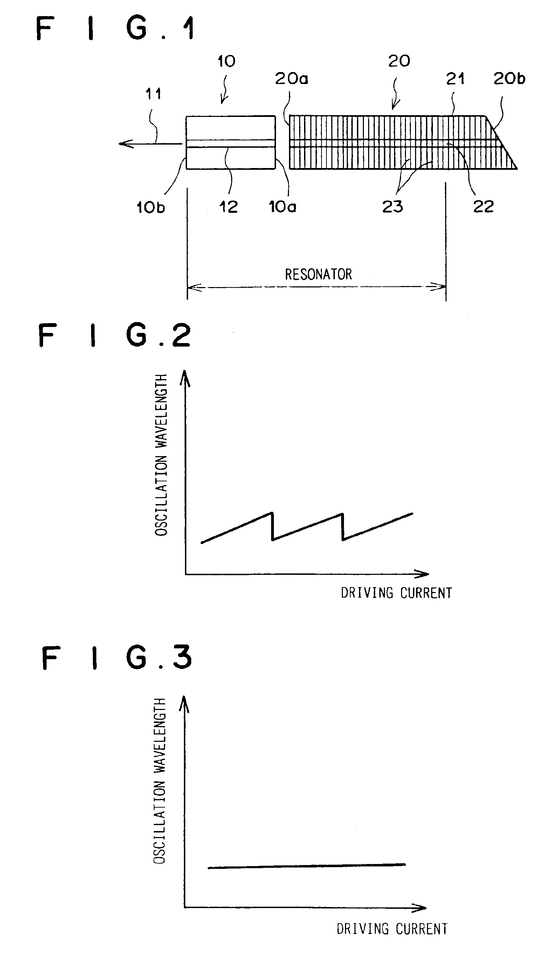

Fig. 1 is a diagram illustrating the construction of a laser light source as the first embodiment of the present invention. The laser light source of Fig. 1 comprises a semiconductor laser element (chip) 10 as a semiconductor light-emitting element which emits a laser beam 11, and a waveguide-type wavelength selection element 20 which is butt-coupled to the semiconductor laser element 10 at one end of the semiconductor laser element 10.

The semiconductor laser element 10 comprises an optical waveguide 12 including an active region. An antireflection (AR) coating is provided on an end face lOa of the semiconductor laser element 10, at which the semiconductor laser element 10 is butt-coupled to the waveguide-type wavelength selection element 20. The antireflection (AR) coating exhibits a reflectance of 0.5% or less at an oscillation wavelengt $\lambda$ (which is 950 nm in this example as explained later). A low-reflection (LR) coating for the oscillation wavelength $\lambda$ is provided on the opposite end face 10b of the semiconductor laser element 10. The length of the semiconductor laser element 10 is, for example, 1 mm.

The waveguide-type wavelength selection element 20 is made by forming an optical channel waveguide 22 on a substrate 21, and arranging a DBR (distributed Bragg reflector) grating 23 along the direction of light propagation in the optical channel waveguide 22. The substrate 21 is made of, for example, a LiNbO$_3$ crystal doped with 5 mol% MgO, which is hereinafter called the MgO-LN substrate. The pitch Ag of the DBR grating 23 is expressed as follows.

$$\Lambda g = q\lambda/2Neff,$$

where q=1, 2, 3, ... , l is the wavelength of the guided light, and Neff is an effective refractive index of the optical channel waveguide 22. In this example, q=1, $\lambda$=950 nm, Neff=2.21, and Ag=0.214 $\mu$m. The grating length is about 1 to 3 mm, and the chip length is also about 1 to 3 mm, so that a reflectance of 90% or more is realized for the oscillation wavelength $\lambda$. Both end faces 20a and 20b of the waveguide-type wavelength selection element 20, which include end faces of the optical channel waveguide 22, are cut and polished, and antireflection coatings for the oscillation wavelength $\lambda$ are provided on the polished end faces 20a and 20b. In addition, the waveguide-type wavelength selection element 20 is formed so that the mode field diameter of the waveguide-type wavelength selection element 20 is almost identical to the mode field diameter of the light emission in the semiconductor laser element 10.

The semiconductor laser element 10 and the waveguide-type wavelength selection element 20 are arranged so that end faces of the optical waveguide 12 and the optical channel waveguide 22 are opposite each other, and the end face 10a of the semiconductor laser element 10 and the end face 20a of the waveguide-type wavelength selection element 20 are close to each other. In this example, the distance between the end faces 10a and 20a is 1.5 $\mu$m or less. Alternatively, the end face 10a may be in contact with the end face 20a. When the semiconductor laser element 10 and the waveguide-type wavelength selection element 20 are arranged as above, guided light in the semiconductor laser element 10 and the waveguide-type wavelength selection element 20 are coupled, i.e., a butt-coupled state is realized.

The operations of the above laser light source are explained below.

A laser beam 11 having a center wavelength of 950 nm is emitted from the forward-side end face lOb of the semiconductor laser element 10. The laser beam 11 is used for a predetermined use such as image formation as explained later.

Light having a center wavelength of 950 nm is also emitted from the backside end face 10a. This light enters and propagates through the optical channel waveguide 22 in the waveguide-type wavelength selection element 20, and a portion of the light is reflected and diffracted by the DBR grating 23, and returns to the semiconductor laser element 10. Since the DBR grating 23 has the function of selecting a wavelength, a wavelength of the above portion of light reflected and diffracted by the DBR grating 23 is selected, and the wavelength-selected light returns to the semiconductor laser element 10. Therefore, the oscillation wavelength of the semiconductor laser element 10 is selected and locked. Thus, the laser beam 11 having the wavelength of 950 nm is obtained.

In particular, since the aforementioned antireflection (AR) coatings are provided on the end face 10a of the semiconductor laser element 10 and the end face 20a of the waveguide-type wavelength selection element 20, substantially, oscillation in a Fabry-Perot mode does not occur either between the opposite end faces 10a and lOb of the semiconductor laser element 10 or between the end face lOb of the semiconductor laser element 10 and the end face 20a of the waveguide-type wavelength selection element 20. That is, in the construction of Fig. 1, a Fabry-Perot type external resonator is realized between the end face lOb of the semiconductor laser element 10 and the DBR grating 23, and the laser beam 11 oscillates substantially only in this external resonator. Therefore, the oscillation wavelength of the laser light source of Fig. 1 is the selected wavelength of the external resonator.

Thus, even when the optical length of the semiconductor laser element 10 varies due to variation of the driving current injected into the semiconductor laser element 10, the oscillation wavelength does not vary. Consequently, the mode hopping does not occur even when the driving current varies, and the noise production due to the mode hopping can be prevented. Therefore, when the laser light source as the first embodiment is used as a recording light source in an image forming apparatus which produces images having density gradation, and the semiconductor laser element 10 is directly modulated, the repeatability of the modulated laser beam is high.

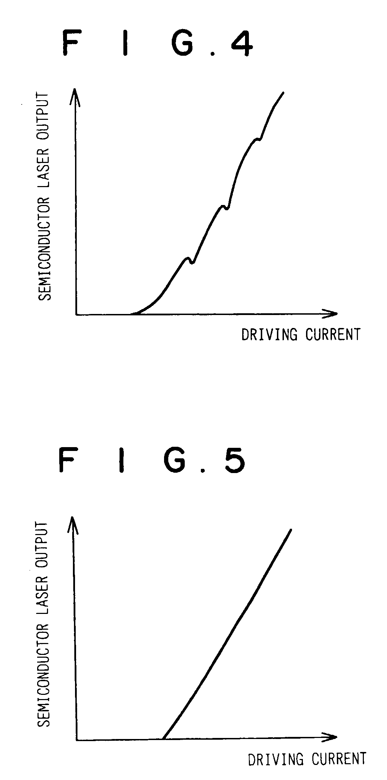

Fig. 2 is a diagram schematically illustrating a relationship between the driving current and the oscillation wavelength in the conventional laser light source, and Fig. 3 is a diagram schematically illustrating a relationship between the driving current and the oscillation wavelength in the laser light source as the first embodiment, where both the conventional laser light source and the laser light source in the first embodiment comprise a composite resonator formed by a semiconductor laser element and an external resonator. As illustrated in Fig. 2, in the conventional laser light source, the oscillation wavelength varies and hops when the driving current varies, i.e., the mode hopping occurs. On the other hand, in the laser light source as the first embodiment, as illustrated in Fig. 3, the oscillation wavelength does not vary, i.e., is maintained constant, even when the driving current varies.

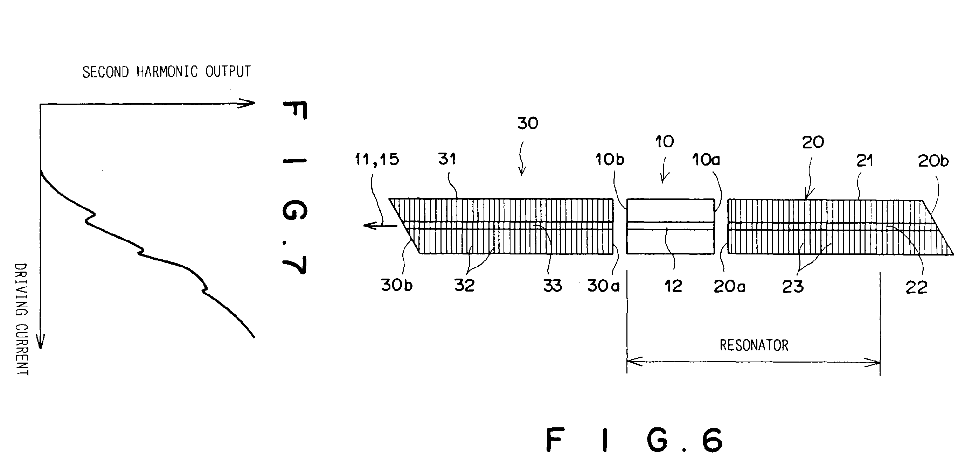

Fig. 4 is a diagram schematically illustrating a relationship between the driving current and the output power of the conventional laser light source, and Fig. 5 is a diagram schematically illustrating a relationship between the driving current and the output power of the above laser light source as the first embodiment. As illustrated in Fig. 4, in the conventional laser light source, a great amount of noise is produced due to the mode hopping caused by the variation of the driving current. On the other hand, in the laser light source as the first embodiment, the noise production is prevented, and linearity is maintained in the relationship between the driving current and the output power of the laser light source, as illustrated in Fig. 5.

Further, in the laser light source as the first embodiment of the present invention, the laser beam 11 exits from the end face 10b, which is located farther from the waveguide-type wavelength selection element 20 than the other end face 10a of the semiconductor laser element 10. Therefore, the internal power of the semiconductor laser element 10 can be lowered, compared with the conventional laser light source in which the laser beam oscillated in the external resonator is output through the wavelength selection element. Consequently, it is possible to prevent the semiconductor laser element 10 from being damaged due to the increase in the internal power.

Furthermore, the end face 20b of the waveguide-type wavelength selection element 20 is cut at a bevel with respect to the direction of the optical channel waveguide 22. Therefore, light reflected at the end face 20b does not enter the optical channel waveguide 22. Since light reflected at the end face 20b does not return to the semiconductor laser element 10, it is possible to prevent noise production and output variation which will be caused by the returned light.

Although the waveguide-type wavelength selection element 20 in the laser light source as the first embodiment is formed by arranging the optical channel waveguide and the DBR grating on the MgO-LN substrate, other wavelength selection elements can be used. For example, the wavelength selection elements which are disclosed in Japanese Patent Applications Nos. 2000-085973 and 2000-085974 can be used. The contents of Japanese Patent Applications Nos. 2000-085973 and 2000-085974 are incorporated in this specification by reference. These wavelength selection elements are formed by arranging on a substrate made of Si or quartz an optical channel waveguide and a DBR grating which are made of a core material having a refractive index of 1.75 to 2.3.

(2) Second Embodiment

Fig. 6 is a diagram illustrating the construction of a laser light source as the second embodiment of the present invention. In Fig. 6, elements having the same reference numbers as Fig. 1 have basically the same functions as the corresponding elements in Fig. 1. The laser light source of Fig. 6 is different from the laser light source of Fig. 1 in that the laser light source of Fig. 6 additionally comprises a waveguide-type optical wavelength conversion element 30 which is butt-coupled to the forward-side end face 1Ob of the semiconductor laser element 10. The other construction of the laser light source of Fig. 6 is basically the same as the construction of Fig. 1.

The optical wavelength conversion element 30 is formed by arranging on a substrate 31 a domain-inverted structure and an optical channel waveguide 33 which extends along the domain-inverted structure. The substrate 31 is made of, for example, a $LiNbO_3$ crystal doped with 5 mol% MgO (hereinafter called a MgO-LN substrate), where $LiNbO_3$ is a ferroelectric exhibiting a nonlinear effect. The domain-inverted structure is formed by periodically arranging a plurality of domain-inverted portions 32. In each of the plurality of domain-inverted portions 32, the direction of the spontaneous polarization, which is originally parallel with the z-axis of the substrate 31, is inverted.

Both end faces 30a and 30b of the optical wavelength conversion element 30, which include end faces of the optical channel waveguide 33, are optically polished. An antireflection coating for the laser beam 11 (as the fundamental wave) is provided on the polished end face 30a, and another antireflection coating for the laser beam 11 and a second harmonic 15 (which is explained later) is provided on the other polished end face 30b.

The semiconductor laser element 10 and the optical wavelength conversion element 30 are arranged so that the end faces of the optical waveguide 12 and the optical channel waveguide 33 are opposite each other, and the end faces 1Ob and 30a are close to each other. For example, the distance between the end faces 1Ob and 30a is 2 μm or less. Alternatively, the end face 1Ob may be in contact with the end face 30a. When the semiconductor laser element 10 and the optical wavelength conversion element 30 are arranged as above, guided light in the semiconductor laser element 10 and the optical wavelength conversion element 30 are coupled, i.e., a butt-coupled state is realized.

In the laser light source of Fig. 6, when the laser beam 11 enters the optical wavelength conversion element 30, the laser beam 11 is converted into the second harmonic 15, where the wavelength of the second harmonic 15 is one-half the wavelength of the laser beam 11. Then, both the laser beam 11 and the second harmonic 15 exit from the end face 30b of the optical wavelength conversion element 30. Alternatively, when an appropriate coating which stops the laser beam 11 is provided on the end face 30b, only the second harmonic 15 exits from the end face 30b.

In the laser light source of Fig. 6, the oscillation wavelength of the semiconductor laser element 10 which is selected by the wavelength selection element 20 is 1.02 $\mu$m. Antireflection (AR) coatings having a reflectance of 4% at the wavelength of 1.02 $\mu$m are provided on the end face 10a of the semiconductor laser element 10 and the end face 20a of the waveguide-type wavelength selection element 20. In addition, the distance between the end face 10a of the semiconductor laser element 10 and the end face 20a of the waveguide-type wavelength selection element 20 is 1.5 $\mu$m, which is approximately a half-integer multiple of the above selected wavelength. Therefore, light reflected at the end face 10a and light reflected at the end face 20a interfere with each other so as to cancel each other out. That is, the effect of reducing the reflected light is enhanced.

It is preferable that antireflection (AR) coatings are provided on the end face lOa of the semiconductor laser element 10 and the end face 20a of the waveguide-type wavelength selection element 20, as above. However, when the distance between the end face 10a of the semiconductor laser element 10 and the end face 20a of the waveguide-type wavelength selection element 20 is approximately a half-integer multiple of the selected wavelength, and the coatings having an approximately identical reflectance are provided on both of the end faces 10a and 20a, the effect of reducing the reflected light is achieved even if the coatings are not antireflection coatings.

When the laser light source of Fig. 6 is actually assembled, the distance between the end face 10a of the semiconductor laser element 10 and the end face 20a of the waveguide-type wavelength selection element 20 varies due to deviations which occur when the semiconductor laser element 10 and the waveguide-type wavelength selection element 20 are aligned and fixed. The variation of the distance is usually about 0.2 $\mu$m. For example, when the oscillation wavelengt $\lambda$ is about 1 $\mu$m, the above variation of the distance nearly equals $\lambda/4$. Although it is technically possible to provide antireflection coatings which realize a reflectance of 0.1% on the end faces, such antireflection coatings are expensive. When the above variation of the distance and the cost of the antireflection coatings are considered, it is preferable that antireflection coatings which realize a reflectance of 0.1 to 0.8% are provided on the end faces 10a and 20a, and the distance between the end faces 10a and 20a is fixed to a half-integer multiple of the selected wavelength $\lambda$ with a precision of $\lambda/4$. When the laser light source is assembled under the above conditions, the substantial reflectance of the antireflection optical system can be made 0.5% or less.

Due to the above construction, the laser beam 11 oscillates substantially only in an external resonator formed between the forward end face 10b of the semiconductor laser element 10 and the DBR grating 23. Therefore, the laser light source as the second embodiment of the present invention also has the same advantages as the first embodiment.

In addition, since the output power of the second harmonic is proportional to the square of the output power of the fundamental wave, the variation of the output power of the second harmonic becomes great when the mode hopping occurs, and repeatability of the driving current-second harmonic output characteristic of the laser light source is further lowered due to the mode hopping. However, according to the second embodiment of the present invention, the variation of the oscillation wavelength and the mode hopping can be suppressed. Therefore, the variation of the second harmonic 15 can be effectively prevented in the second embodiment of the present invention.

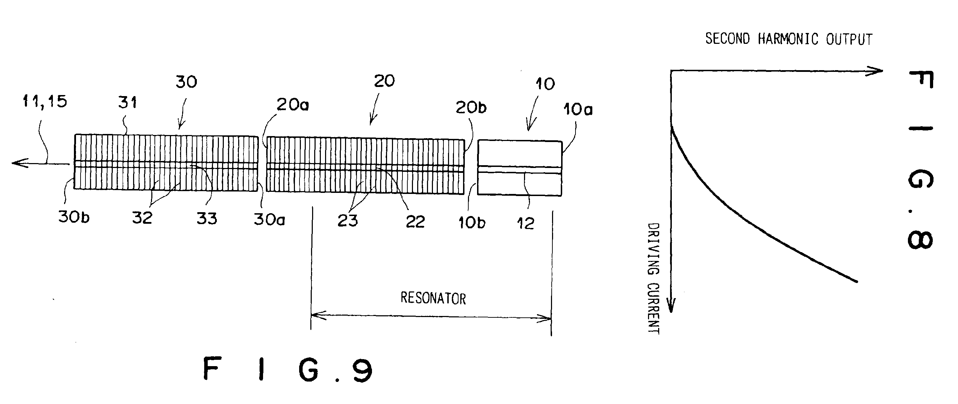

Fig. 7 is a diagram schematically illustrating a relationship between the driving current and the output power of the second harmonic in a conventional laser light source, and Fig. 8 is a diagram schematically illustrating a relationship between the driving current and the output power of the second harmonic in the laser light source as the second embodiment of the present invention, where both of the conventional laser light source and the laser light source in the second embodiment comprise an optical wavelength conversion element and a composite resonator formed by a semiconductor laser element and an external resonator. As illustrated in Fig. 7, in the conventional laser light source, a great amount of noise is produced due to the mode hopping caused by the variation of the driving current. On the other hand, as illustrated in Fig. 8, in the laser light source as the second embodiment, the noise production is prevented.

Further, the end face 30b of the optical wavelength conversion element 30 is cut at a bevel with respect to the direction of the optical channel waveguide 33. Therefore, light reflected at the end face 30b does not enter the optical channel waveguide 33 of the optical wavelength conversion element 30. Consequently, the above light reflected at the end face 30b does not return to the semiconductor laser element 10. Thus, it is possible to prevent noise production and output variation which may be caused by the returned light.

(3) Third Embodiment

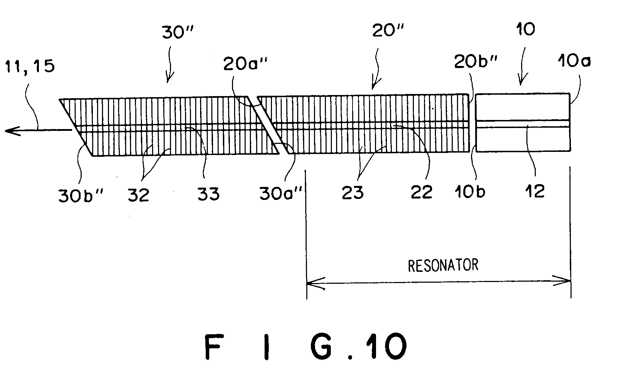

Fig. 9 is a diagram illustrating the construction of a laser light source as the third embodiment of the present invention. In Fig. 9, elements having the same reference numbers as Fig. 6 have basically the same functions as the corresponding elements in Fig. 6. The laser light source of Fig. 9 is different from the laser light source of Fig. 6 in that the waveguide-type wavelength selection element 20' is arranged between the semiconductor laser element 10 and the optical wavelength conversion element 30', instead of being arranged on the backside of the semiconductor laser element 10. In this example, the waveguide-type wavelength selection element 20' is butt-coupled to each of the semiconductor laser element 10 and the optical wavelength conversion element 30'.

In the third embodiment of the present invention, unlike the first and second embodiments of the present invention, a portion of light which exits from the forward-side end face lOb of the semiconductor laser element 10 (i.e., a portion of light which enters the waveguide-type wavelength selection element 20') is reflected and diffracted by the DBR grating 23 in the waveguide-type wavelength selection element 20', and returns to the semiconductor laser element 10. Since the DBR grating 23 has the function of selecting a wavelength, the wavelength of the reflected and diffracted portion of light is selected, and the wavelength-selected light returns to the semiconductor laser element 10. Therefore, the oscillation wavelength of the semiconductor laser element 10 is selected and locked.

In the construction of Fig. 9, antireflection coatings for the oscillation wavelength are provided on the end face lOb of the semiconductor laser element 10 and the end face 20b' of the waveguide-type wavelength selection element 20'. Therefore, substantially, oscillation of a Fabry-Perot mode does not occur either between the opposite end faces 10a and 10b of the semiconductor laser element 10 or between the end face 10a of the semiconductor laser element 10 and the end face 20b' of the waveguide-type wavelength selection element 20'. That is, in the construction of Fig. 9, a Fabry-Perot type external resonator is realized between the end face 10a of the semiconductor laser element 10 and the DBR grating 23, and the laser beam 11 oscillates substantially only in this external resonator. Thus, the oscillation wavelength of the laser light source of Fig. 9 is the selected wavelength of the external resonator.

Therefore, even when the optical length of the semiconductor laser element 10 varies with the variation of the driving current injected into the semiconductor laser element 10, the oscillation wavelength does not vary. Consequently, the mode hopping does not occur even when the driving current varies, and noise production due to the mode hopping can be prevented.

Since the variation of the oscillation wavelength and the mode hopping can also be suppressed in the third embodiment, the variation of the output power of the second harmonic due to the mode hopping can be surely suppressed, and the lowering of repeatability of the driving current-second harmonic output characteristic of the laser light source can be prevented.

(4) Fourth Embodiment

Fig. 10 is a diagram illustrating the construction of a laser light source as the fourth embodiment of the present invention. In Fig. 10, elements having the same reference numbers as Fig. 9 have basically the same functions as the corresponding elements in Fig. 9. The laser light source of Fig. 10 is different from the laser light source of Fig. 9 in that the end face 20a" of the waveguide-type wavelength selection element 20" and the end faces 30a" and 30b" of the optical wavelength conversion element 30" are cut at a bevel with respect to the direction in which the optical waveguides 22 and 33 extend. Therefore, light reflected at the end face 20a", 30a", or 30b" does not return to the semiconductor laser element 10. Consequently, it is possible to prevent noise production and output variation which may be caused by the returned light.

(5) Fifth Embodiment

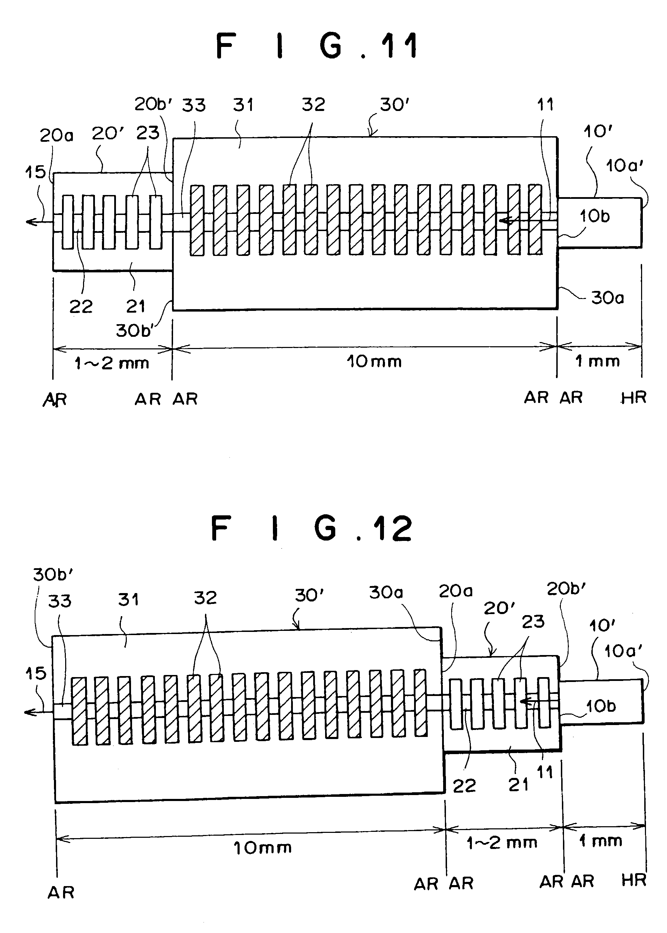

Fig. 11 is a diagram illustrating the construction of a laser light source as the fifth embodiment of the present invention. In Fig. 11, elements having the same reference numbers as Fig. 9 have basically the same functions as the corresponding elements in Fig. 9. The laser light source of Fig. 11 is different from the laser light source of Fig. 9 in that the optical wavelength conversion element 30' is arranged between the semiconductor laser element 10' and the waveguide-type wavelength selection element 20'. In this example, the optical wavelength conversion element 30' is butt-coupled to each of the semiconductor laser element 10' and the waveguide-type wavelength selection element 20'.

A high-reflection (HR) coating for the wavelength of the laser beam 11 is provided on an end face 10a' of the semiconductor laser element 10'. An antireflection (AR) coating for the wavelength is provided on the opposite end face 10b of the semiconductor laser element 10', at which the semiconductor laser element 10' is butt-coupled to the optical wavelength conversion element 30'. Antireflection (AR) coatings are provided on both end faces 30a and 30b' of the optical wavelength conversion element 30' and both end faces 20a and 20b' of the waveguide-type wavelength selection element 20'.

In the above construction, a portion of the laser beam 11, which is generated in the semiconductor laser element 10' as a fundamental wave having a certain wavelength, enters the waveguide-type wavelength selection element 20', is reflected and diffracted by the DBR grating 23, and returns to the semiconductor laser element 10'. Therefore, the oscillation wavelength of the semiconductor laser element 10' is selected and locked. Thus, it is possible to obtain a stable second harmonic output 15. Namely, in the construction of Fig. 11, an external resonator in which light having the wavelength selected by the waveguide-type wavelength selection element 20' oscillates is formed between the end face 10a' of the semiconductor laser element 10' and the waveguide-type wavelength selection element 20', and the laser beam 11 generated in the external resonator is converted into the second harmonic 15 by the optical wavelength conversion element 30'.

In the above construction, it is preferable to enhance the efficiency of diffraction and reflection of the light having the selected wavelength in the waveguide-type wavelength selection element 20'. When the efficiency is enhanced, the internal power of the external resonator can be increased. Therefore, it is possible to obtain the second harmonic 15 with greater output power.

(6) Sixth Embodiment

Fig. 12 is a diagram illustrating the construction of a laser light source as the sixth embodiment of the present invention. In Fig. 12, elements having the same reference numbers as Fig. 11 have basically the same functions as the corresponding elements in Fig. 11. The laser light source of Fig. 12 is different from the laser light source of Fig. 11 in the relative positions of the waveguide-type wavelength selection element 20' and the optical wavelength conversion element 30'. That is, the waveguide-type wavelength selection element 20' is arranged between the semiconductor laser element 10' and the optical wavelength conversion element 30'. The end faces of the semiconductor laser element 10', the waveguide-type wavelength selection element 20', and the optical wavelength conversion element 30' are coated in the same manners as the fifth embodiment. Therefore, in the construction of Fig. 12, an external resonator in which light having a wavelength selected by the waveguide-type wavelength selection element 20' oscillates is formed between the end face 10a' of the semiconductor laser element 10' and the waveguide-type wavelength selection element 20', and the laser beam 11 generated in the external resonator is converted into the second harmonic 15 by the optical wavelength conversion element 30'. Therefore, the laser light source of Fig. 12 has substantially the same advantages as those of the laser light source of Fig. 11.

(7) First Use of Laser Light Source

Various examples of uses of the laser light sources according to the present invention are explained below.

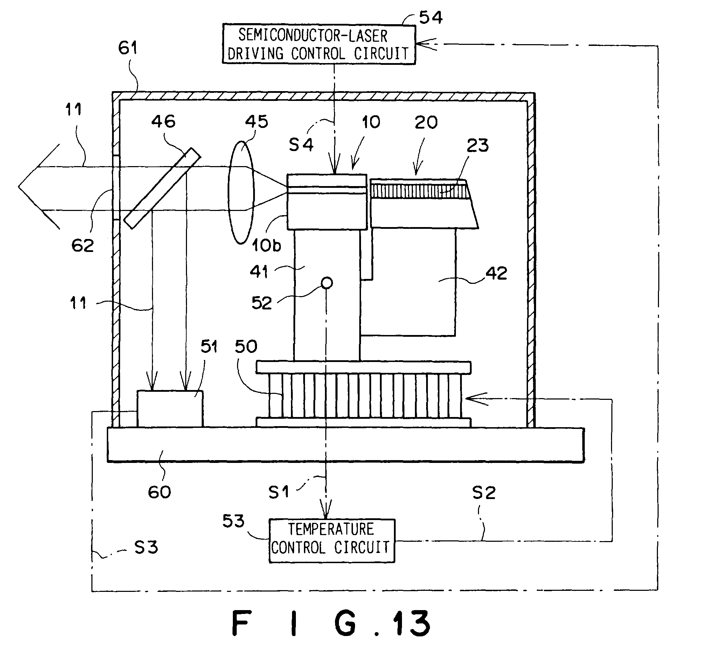

Fig. 13 is a diagram illustrating an example of an arrangement for use of the laser light source of Fig.

1. As illustrated in Fig. 13, the semiconductor laser element (chip) 10 and the waveguide-type wavelength selection element 20 of the laser light source are held in the blocks 41 and 42, respectively. The blocks 41 and 42 are made of a metal having a high thermal conductivity, such as copper. The metal block 42 is fixed to the metal block 41, and the metal block 41 is fixed on an upper surface (as a temperature control surface) of a Peltier element 50.

The arrangement of Fig. 13 further includes a collimator lens 45, a beam splitter 46, and a photodetector 51. The collimator lens 45 collimates the laser beam 11 which is emitted from the semiconductor laser element 10 as divergent light. A portion of the collimated laser beam is branched off by the beam splitter 46, and directed to the photodetector 51. The photodetector 51 is, for example, a photodiode, and detects the intensity of the laser beam 11.

The above construction is contained in a package comprised of a package base 60 and a package cover 61 which covers the package base 60. The package cover 61 has a window 62 made of glass. The laser beam 11 which passes through the beam splitter 46 exits from the package through the glass window 62, and is used for a predetermined purpose.

In addition, a thermistor 52 is provided for detecting the ambient temperature of the external resonator formed between the end face 10b of the semiconductor laser element 10 and the DBR grating 23. The thermistor 52 outputs a temperature detection signal S1, which is then input into a temperature control circuit 53. The temperature control circuit 53 supplies to the Peltier element 50 a Peltier-element driving control signal S2 corresponding to the temperature detection signal S1 so as to control the Peltier element 50. Thus, the ambient temperature of the external resonator is maintained constant, and the variation of the oscillation wavelength caused by temperature variation can be certainly prevented.

Further, the photodetector 51 outputs an optical-intensity detection signal S3, which is fed back to a semiconductor laser driving control circuit 54. The semiconductor-laser driving control circuit 54 varies a driving current S4 which is supplied to the semiconductor laser element 10, based on the optical-intensity detection signal S3, so as to maintain the optical output (of the laser beam 11) at a predetermined level.

(8) Second Use of Laser Light Source

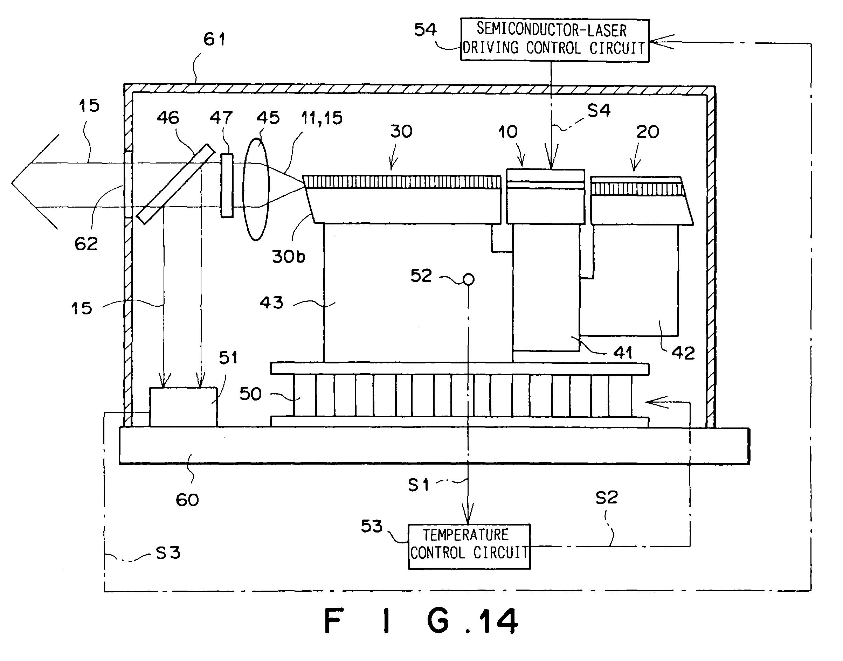

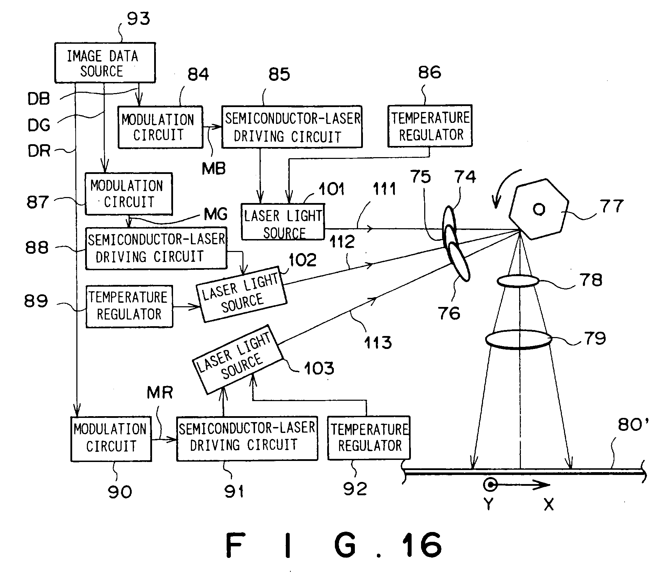

Fig. 14 is a diagram illustrating an example of an arrangement for use of the laser light source illustrated in Fig. 6. As illustrated in Fig. 16, the semiconductor laser element (chip) 10, the waveguide-type wavelength selection element 20, and the optical wavelength conversion element 30 of the laser light source are held in the blocks 41, 42, and 43, respectively. The blocks 41, 42, and 43 are made of a metal having a high thermal conductivity, such as copper. The metal blocks 41 and 42 are fixed to the metal block 43, and the metal block 43 is fixed on an upper surface (as a temperature control surface) of a Peltier element 50.

Although, as explained before, the laser beam 11 (as the fundamental wave) and its second harmonic 15 exit from the end face 30b of the optical wavelength conversion element 30, the laser beam 11 is cut off by a fundamental-wave cut filter 47, which is arranged between the collimator lens 45 and the beam splitter 46 in the construction of Fig. 14. Therefore, in this case, the photodetector 51 detects the optical intensity of a portion of the second harmonic 15 which is branched off by the beam splitter 46, and the semiconductor laser element 10 is controlled by the semiconductor-laser driving control circuit 54 so that the optical intensity of the second harmonic 15 is maintained at a predetermined level.

(9) First Image Forming Apparatus

Next, embodiments of the image forming apparatuses according to the present invention are explained below.

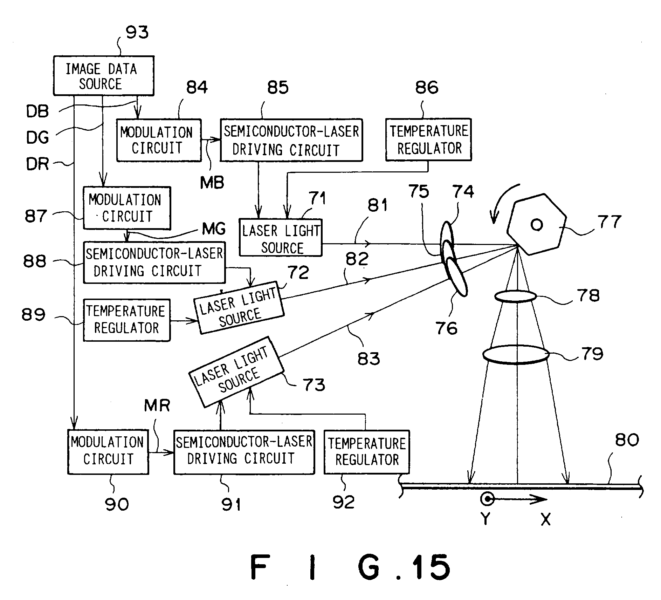

Fig. 15 is a diagram illustrating the construction of an image forming apparatus as the seventh embodiment of the present invention. The image forming apparatus of Fig. 15 is provided for forming a color image on a recording medium 80. As illustrated in Fig. 15, the image forming apparatus of Fig. 15 comprises three laser light sources 71, 72, and 73, cylindrical lenses 74, 75, and 76, a polygon mirror 77, and another cylindrical lens 78, and an f-theta lens 79. The cylindrical lenses 74, 75, and 76 respectively converge laser beams 81, 82, and 83, which are emitted from the laser light sources 71, 72, and 73 for recording the color image, into the plane of Fig. 15. Hereinafter, the laser beams 81, 82, and 83 are called the recording laser beams. The polygon mirror 77 is arranged so that the recording laser beams 81, 82, and 83 are respectively converged by the cylindrical lenses 74, 75, and 76, into a common converging position on a mirror face of the polygon mirror 77. The polygon mirror 77 reflects the converged recording laser beams 81, 82, and 83 so as to be deflected toward the cylindrical lens 78. The cylindrical lenses 74, 75, 76, and 78 constitute a face-inclination-correction optical system. The f-theta lens 79 converges the deflected recording laser beams 81, 82, and 83 into a predetermined spot having a predetermined diameter, regardless of deflected position on the recording medium 80.

Basically, each of the above laser light sources 71, 72, and 73 has the construction of Fig. 13. The oscillation wavelengths λ1, λ2, and λ3 of the laser light sources 71, 72, and 73 are different, and respectively used for forming blue, green, and red on the recording medium 80. As illustrated in Fig. 15, a modulation circuit, a semiconductor laser driving circuit, and a temperature control circuit are provided corresponding to each of the laser light sources 71, 72, and 73, and image data corresponding to each color component of a color image are supplied from an image data source 93 to each modulation circuit.

For example, when image data DB indicating the blue density are supplied to the modulation circuit 84, the modulation circuit 84 generates a modulation signal MB based on the image data DB, and outputs the modulation signal MB to the semiconductor laser driving circuit 85, which controls a driving current which is supplied to the corresponding laser light source 71, based on the modulation signal MB. The temperature regulator 86 is provided for maintaining the temperature of the resonator portion of the laser light source 71 at a predetermined target temperature. The semiconductor laser driving circuit 85 may be: a type which controls based on the modulation signal MB the level of the driving current supplied to the corresponding laser light source 71; a type which controls based on the modulation signal MB a pulse width of a pulsed driving current supplied to the corresponding laser light source 71; a type which controls based on the modulation signal MB the number of pulses of a pulsed driving current supplied to the corresponding laser light source 71; or the like.

When the semiconductor laser driving circuit 85 is the type which controls based on the modulation signal MB the level of the driving current supplied to the corresponding laser light source 71, the recording laser beam 81 is intensity-modulated based on the modulation signal MB. For this purpose, the level of the driving current can be controlled, for example, by using the photodetector 51 and the semiconductor-laser driving control circuit 54 which are illustrated in Fig. 13. For example, the semiconductor-laser driving control circuit 54 (in Fig. 13) may controls the driving current S4 which is supplied to the semiconductor laser element 10 the so that the optical intensity of the recording laser beam 81 becomes the intensity-modulated level corresponding to the modulation signal MB. Alternatively, the driving current may be controlled based on a relationship between the driving current and the optical intensity of the recording laser beam 81, which is obtained in advance by measurement. In the latter case, the relationship can be obtained by measuring the optical intensity when the image forming apparatus is in a quiescent state. A monitoring means such as the photodetector 51 can be used in the measurement, and appropriate values of the driving current, corresponding to respective values of the optical intensity, can be held for use in the control of the level of the driving current during operation.

When the semiconductor laser driving circuit 85 is the type which controls based on the modulation signal MB a pulse width of a pulsed driving current supplied to the corresponding laser light source 71, the recording laser beam 81 is pulse-width modulated based on the image data DB. For this purpose, the values of the pulse width of the driving current, corresponding to respective levels of the modulation signal MB, can be obtained in advance based on a relationship between the driving current and the optical intensity of the recording laser beam 81, and held for use in the control of the pulse width of the driving current during operation. The relationship between the driving current and the optical intensity of the recording laser beam 81 is obtained by measurement, which is performed when the image forming apparatus is in a quiescent state. A monitoring means such as the photodetector 51 can be used in the measurement.

The temperature regulator 86 is realized, for example, by the thermistor 52, the temperature control circuit 53, and the Peltier element 50 in the construction of Fig. 13.

Similarly, when image data DG indicating the green density are supplied to the modulation circuit 87, the modulation circuit 87 generates a modulation signal MG based on the image data DG, and outputs the modulation signal MG to the semiconductor laser driving circuit 88, which controls a driving current which is supplied to the corresponding laser light source 72, based on the modulation signal MG. The temperature regulator 89 is provided for maintaining the temperature of the resonator portion of the laser light source 72 at a predetermined target temperature. The modulation circuit 87, the semiconductor laser driving circuit 88, and the temperature control circuit 89 are realized in the same manners as the modulation circuit 84, the semiconductor laser driving circuit 85, and the temperature control circuit 86, respectively.

In addition, when image data DR indicating the red density are supplied to the modulation circuit 90, the modulation circuit 90 generates a modulation signal MR based on the image data DR, and outputs the modulation signal MR to the semiconductor laser driving circuit 91, which controls a driving current which is supplied to the corresponding laser light source 73, based on the modulation signal MR. The temperature regulator 92 is provided for maintaining the temperature of the resonator portion of the laser light source 73 at a predetermined target temperature. The modulation circuit 90, the semiconductor laser driving circuit 91, and the temperature control circuit 92 are realized in the same manners as the modulation circuit 84, the semiconductor laser driving circuit 85, and the temperature control circuit 86, respectively.

The operations of the image forming apparatus of Fig. 15 are explained below.

The recording laser beams 81, 82, and 83 being emitted from the laser light sources 71, 72, and 73 and having the different wavelengths are reflected and deflected by the polygon mirror 77 so as to scan the recording medium 80 in the X direction (i.e., the main scanning direction). In addition, the recording medium 80 is moved by a sub-scanning (feeding) means (not shown) at a constant speed in the Y direction, which is approximately perpendicular to the X direction. Thus, the recording medium 80 is two-dimensionally scanned with the recording laser beams 81, 82, and 83.

In this example, the recording medium 80 includes color-forming layers for forming blue, green, and red, respectively. When the recording medium 80 is illuminated with the recording laser beams 81, 82, and 83 having the wavelengths λ1, λ2, and λ3, the color-forming layers form blue, green, and red images, respectively. Since the recording laser beams 81, 82, and 83 are respectively modulated with the image data DB, DG, and DR, the color-forming layers included in the recording medium 80 form blue, green, and red with densities corresponding to the image data DB, DG, and DR, respectively, so as to form (record) a color image represented by the image data DB, DG, and DR on the recording medium 80 when the recording medium 80 is two-dimensionally scanned with the recording laser beams 81, 82, and 83. The wavelengths λ1, λ2, and λ3 do not belong to the blue, green, and red wavelength ranges, respectively. In this case, a so-called pseudo color image is formed.

The laser light sources 71, 72, and 73 have basically the same construction as the construction of Fig. 13. Therefore, the oscillation wavelength in each laser light source does not vary even when the optical length of the semiconductor laser element in each laser light source varies due to variation of the driving current injected into the semiconductor laser element. Consequently, the mode hopping due to the variation of the driving current does not occur, and noise production caused by the mode hopping can be prevented. Thus, in the image forming apparatus of Fig. 15, the noise production caused by the mode hopping can be prevented even when the recording laser beams 81, 82, and 83 are intensity-modulated, pulse-width modulated, or pulse-number modulated, and therefore high-quality color images can be formed on the recording medium 80. In addition, since the repeatability of the modulated laser beams, which are obtained when the laser light sources 71, 72, and 73 are modulated, is high, the repeatability of the image density is also maintained high.

Alternatively, the recording medium 80 may be a type which forms blue, green, and red images when the recording medium 80 is illuminated with the recording laser beams 81, 82, and 83, and then undergoes a wet or dry developing process. In addition, although the above recording medium 80 used in the seventh embodiment is a positive type, alternatively, a negative-type recording medium in which a negative image is formed may be used instead of the positive-type recording medium 80. In this case, a positive image can be produced in a positive-type recording medium by using the negative image which is formed in the negative-type recording medium by illumination with the recording laser beams 81, 82, and 83.

(10) Second Image Forming Apparatus

Fig. 16 is a diagram illustrating the construction of an image forming apparatus as the eighth embodiment of the present invention. The image forming apparatus of Fig. 16 is different from the image forming apparatus of Fig. 15 in that the recording medium 80' includes color-forming layers which respectively form colors of yellow, magenta, and cyan when the recording medium 80' is illuminated with the recording laser beams 111, 112, and 113 respectively having wavelengths in the blue, green, and red wavelength ranges.

The laser light source 101 has, for example, the construction of Fig. 14, in which a laser beam as a fundamental wave is converted by an optical wavelength conversion element into the laser beam 111 (which is a second harmonic) having a wavelength in the blue wavelength range. The laser light source 102 has, for example, the construction of Fig. 14, in which a laser beam as a fundamental wave is converted by an optical wavelength conversion element into the laser beam 112 (which is a second harmonic) having a wavelength in the green wavelength range. The laser light source 103 has, for example, the construction of Fig. 13, and emits the laser beam 113 having a wavelength in the red wavelength range.

Like the image forming apparatus of Fig. 15, the recording laser beams 111, 112, and 113 are modulated, and the recording medium 80' is two-dimensionally scanned with the modulated recording laser beams 111, 112, and 113 so that a color image is formed in the recording medium 80'.

Since the laser light sources 101, 102, and 103 have the constructions of Figs. 13 and 14, the oscillation wavelength in each laser light source does not vary even when the optical length of the semiconductor laser element in each laser light source varies due to variation of the driving current injected into the semiconductor laser element. Therefore, the mode hopping due to the variation of the driving current does not occur, and noise production caused by the mode hopping can be prevented. Consequently, in the image forming apparatus of Fig. 16, the noise production caused by the mode hopping can be prevented even when the recording laser beams 111, 112, and 113 are intensity-modulated, pulse-width modulated, or pulse-number modulated, and therefore high-quality color images can be formed on the recording medium 80'. In addition, since the repeatability of the modulated laser beams, which are obtained when the laser light sources 101, 102, and 103 are modulated, is high, the repeatability of the image density is also maintained high.

In addition, all of the contents of Japanese Patent Applications, Nos. 11(1999)-345724, 2000-157792, 2000-196166 and 2000-326383 are incorporated into this specification by reference.

**Claims**

1. A laser light source comprising:

a semiconductor light-emitting element which has first and second end faces at opposite ends thereof, and emits light; and
a waveguide-type wavelength selection element which has a third end face at one end thereof, and selects a wavelength of said light emitted from said semiconductor light-emitting element;
said first end face of said semiconductor light-emitting element and said third end face of said waveguide-type wavelength selection element are butt-coupled, an antireflection optical system for said wavelength selected by said waveguide-type wavelength selection element is formed between said first end face of said semiconductor light-emitting element and said third end face of said waveguide-type wavelength selection element, said second end face and said waveguide-type wavelength selection element form an external resonator in which light having said wavelength selected by said waveguide-type wavelength selection element resonates, and said light which resonates in said external resonator exits from said second end face of said semiconductor light-emitting element.

2. A laser light source according to claim 1, wherein antireflection coatings are provided on said first end face of said semiconductor light-emitting element and said third end face of said waveguide-type wavelength selection element so as to form said antireflection optical system.

3. A laser light source according to claim 1, wherein said antireflection optical system has a reflectance of 0.5% or less at said wavelength selected by said waveguide-type wavelength selection element.

4. A laser light source according to claim 1, wherein said first end face of said semiconductor light-emitting element and said third end face of said waveguide-type wavelength selection element have an approximately identical reflectance at said wavelength selected by said waveguide-type wavelength selection element, and a distance between said first end face of said semiconductor light-emitting element and said third end face of said waveguide-type wavelength selection element is an approximately half-integer multiple of the wavelength selected by the waveguide-type wavelength selection element.

5. A laser light source according to claim 1, wherein said first end face of said semiconductor light-emitting element and said third end face of said waveguide-type wavelength selection element have a reflectance of 0.1 to 0.8% at said wavelength selected by said waveguide-type wavelength selection element, and a distance between said first end face of said semiconductor light-emitting element and said third end face of said waveguide-type wavelength selection element is {(2N-1)/2 - 0.25} to {(2N-1)/2 + 0.25} times the wavelength selected by the waveguide-type wavelength selection element, where N is an arbitrary natural number.

6. A laser light source according to claim 1, wherein said wavelength selection element comprises a reflective grating by which said wavelength is selected.

7. A laser light source according to claim 1, wherein a distance between said first end face of said semiconductor light-emitting element and said third end face of said waveguide-type wavelength selection element is 1.5 times the wavelength selected by the waveguide-type wavelength selection element or less.

8. A laser light source according to claim 1, wherein another end, opposite to said one end, of said waveguide-type wavelength selection element is cut at a bevel with respect to a direction in which an optical waveguide in said waveguide-type wavelength selection element extends.

9. A laser light source comprising:

a semiconductor light-emitting element which has first and second end faces at opposite ends thereof, and emits light; a waveguide-type wavelength selection element which has a third end face at one end thereof, and selects a wavelength of said light emitted from said semiconductor light-emitting element, where said first end face of said semiconductor light-emitting element and said third end face of said waveguide-type wavelength selection element are optically coupled, an antireflection optical system for said wavelength selected by said waveguide-type wavelength selection element is formed between said first end face of said semiconductor light-emitting element and said third end face of said waveguide-type wavelength selection element, and said second end face and said waveguide-type wavelength selection element form an external resonator in which light having said wavelength selected by said waveguide-type wavelength selection element resonates; and an optical wavelength conversion element which is butt-coupled to at least one of said semiconductor light-emitting element and said waveguide-type wavelength selection element so that said semiconductor light-emitting element, said waveguide-type wavelength selection element, and said optical wavelength conversion element are butt-coupled, and said optical wavelength conversion element converts the wavelength of said light which resonates in said external resonator, into another wavelength, and outputs light having said another wavelength.

10. A laser light source according to claim 9, wherein antireflection coatings are provided on said first end face of said semiconductor light-emitting element and said third end face of said waveguide-type wavelength selection element so as to form said antireflection optical system.

11. A laser light source according to claim 9, wherein said antireflection optical system has a reflectance of 0.5% or less at said wavelength selected by said waveguide-type wavelength selection element.

12. A laser light source according to claim 9, wherein said first end face of said semiconductor light-emitting element and said third end face of said waveguide-type wavelength selection element have an approximately identical reflectance at said wavelength selected by said waveguide-type wavelength selection element, and a distance between said first end face of said semiconductor light-emitting element and said third end face of said waveguide-type wavelength selection element is an approximately half-integer multiple of the wavelength selected by the waveguide-type wavelength selection element.

13. A laser light source according to claim 9, wherein said first end face of said semiconductor light-emitting element and said third end face of said waveguide-type wavelength selection element have a reflectance of 0.1 to 0.8% at said wavelength selected by said waveguide-type wavelength selection element, and a distance between said first end face of said semiconductor light-emitting element and said third end face of said waveguide-type wavelength selection element is {(2N-1)/2 - 0.25} to {(2N-1)/2 + 0.25} times the wavelength selected by the waveguide-type wavelength selection element, where N is an arbitrary natural number.

14. A laser light source according to claim 9, wherein said wavelength selection element comprises a reflective grating by which said wavelength is selected.

15. A laser light source according to claim 9, wherein a distance between said first end face of said semiconductor light-emitting element and said third end face of said waveguide-type wavelength selection element is 1.5 times the wavelength selected by the waveguide-type wavelength selection element or less.

16. A laser light source according to claim 9, wherein another end, opposite to said one end, of said waveguide-type wavelength selection element is cut at a bevel with respect to a direction in which an optical waveguide in said waveguide-type wavelength selection element extends.

17. An image forming apparatus having, as a light source for recording an image having density gradation, a laser light source which comprises:

a semiconductor light-emitting element which has first and second end faces at opposite ends thereof, and emits light; and
a waveguide-type wavelength selection element which has a third end face at one end thereof, and selects a wavelength of said light emitted from said semiconductor light-emitting element;
said first end face of said semiconductor light-emitting element and said third end face of said waveguide-type wavelength selection element are butt-coupled, an antireflection optical system for said wavelength selected by said waveguide-type wavelength selection element is formed between said first end face of said semiconductor light-emitting element and said third end face of said waveguide-type wavelength selection element, said second end face and said waveguide-type wavelength selection element form an external resonator in which light having said wavelength selected by said waveguide-type wavelength selection element resonates, and said light which resonates in said external resonator exits from said second end face of said semiconductor light-emitting element.

18. An image forming apparatus having, as a light source for recording an image having density gradation, a laser light source which comprises:

a waveguide-type wavelength selection element which has a third end face at one end thereof, and selects a wavelength of said light emitted from said semiconductor light-emitting element, where said first end face of said semiconductor light-emitting element and said third end face of said waveguide-type wavelength selection element are optically coupled, an antireflection optical system for said wavelength selected by said waveguide-type wavelength selection element is formed between said first end face of said semiconductor light-emitting element and said third end face of said waveguide-type wavelength selection element, and said second end face and said waveguide-type wavelength selection element form an external resonator in which light having said wavelength selected by said waveguide-type wavelength selection element resonates; and an optical wavelength conversion element which is butt-coupled to at least one of said semiconductor light-emitting element and said waveguide-type wavelength selection element so that said semiconductor light-emitting element, said waveguide-type wavelength selection element, and said optical wavelength conversion element are butt-coupled, and said optical wavelength conversion element converts the wavelength of said light which resonates in said external resonator, into another wavelength, and outputs light having said another wavelength.

# F I G . 1

RESONATOR

# F I G . 2

OSCILLATION WAVELENGTH

DRIVING CURRENT

# F I G . 3

OSCILLATION WAVELENGTH

DRIVING CURRENT

# F I G . 4

SEMICONDUCTOR LASER OUTPUT

DRIVING CURRENT

# F I G . 5

SEMICONDUCTOR LASER OUTPUT

DRIVING CURRENT

F I G . 6

F I G . 7

# F I G . 8

SECOND HARMONIC OUTPUT

DRIVING CURRENT

# F I G . 9

F I G . 10

EP 1 130 717 A2

# F I G . 11

# F I G . 12

F I G . 13

SEMICONDUCTOR-LASER DRIVING CONTROL CIRCUIT

TEMPERATURE CONTROL CIRCUIT

EP 1 130 717 A2

F I G .14

EP 1 130 717 A2

**93**

IMAGE DATA
SOURCE

DB

DG

DR

**84**

MODULATION
CIRCUIT

MB

**85**

SEMICONDUCTOR-LASER
DRIVING CIRCUIT

**86**

TEMPERATURE
REGULATOR

**87**

MODULATION
CIRCUIT

MG

**88**

SEMICONDUCTOR-LASER
DRIVING CIRCUIT

**89**

TEMPERATURE
REGULATOR

**71**

LASER LIGHT
SOURCE

**72**

LASER LIGHT
SOURCE

**73**

LASER LIGHT
SOURCE

MR

**90**

MODULATION
CIRCUIT

**91**

SEMICONDUCTOR-LASER
DRIVING CIRCUIT

**92**

TEMPERATURE
REGULATOR

**81**

**82**

**83**

**75**

**74**

**76**

**77**

O

**78**

**79**

**80**

Y    X

# F I G .15

F I G . 16

EP 1 130 717 A2

# F I G . 17

# F I G . 18

27

F I G . 19